# EUROPEAN PATENT APPLICATION

(11) **EP 3 971 993 A1**
(43) Date of publication of application: **23.03.2022**
(21) Application number: 20196539.9
(22) Date of filing: 16.09.2020
(51) Int. Cl.: H01L 31/0224

(54) **MANUFACTURING METHOD FOR BACK STRUCTURE OF DOUBLE-SIDED P-TYPE SOLLAR CELL**

(71) Applicant: Jbao Technology Ltd., Hsinchu County 30273 (TW)
(72) Inventor: Shan, Ling-Pao, 30273 Hsinchu County (TW)
(74) Representative: Cabinet Chaillot

(57) **Abstract**

The present invention discloses a manufacturing method for the back-side structure of a double-sided P-type solar cell, which includes a continuous opening on the passivation layer and using the alignment printing of aluminum paste or metal sputtering/evaporation to grow a layer of aluminum metal layer. The continuous opening on the passivation layer is completely covered, and is finally sintered to form an aluminum-metal silicide (AlSix), which is characterized in that: a good electrical contact path can be formed on the back-side of the solar cell substrate 1 with the cathode during the electroplating process; Thus, the impedance can be significantly decreased and a complete electroplating circuit can be formed which is beneficial to facilitate the high currents flow during electroplating, thereby improving electroplating efficiency and mass production yield rate.

## Description

### BACKGROUND OF THE INVENTION

### 1. Field of the Invention

The present invention relates to a manufacturing method for the back-side structure of a double-sided P-type solar cell, wherein the method provides a simple and feasible process by replacing silver paste printing with copper electroplating for the double-sided P-type sollar cell, thereby greatly reducing the production cost of the double-sided P-type sollar cell; meanwhile, by using copper electroplating instead of silver paste screen printing, the method can increase the effective light-receiving area and also increase the fill factor (FF) of the double-sided P-type solar cell to improve the overall power generation efficiency of the solar cell.

### 2. Description of the Prior Art

With the expansion and rapid development of the photovoltaic industry, the double-sided P-type cell technology has been widely adopted by most solar cell manufacturers since it is first introduced in ISFH and SolarWorld in 2015. The rapid commercial application of the double-sided P-type sollar cell is mainly due to its manufacturing process very similar to that of the single-sided PERC solar cell, which is also the mainstream technology in the current photovoltaic industry. For existing P-type solar cell, screen printed silver paste is still used for manufacturing the front side of the solar cell, while a large amount of aluminum paste and silver aluminum paste are used on the back-side to make grid lines; silver paste, silver aluminum paste, and aluminum paste account for around 25% of the total cost of producing photovoltaic cells. Obviously, for the double-sided P-type solar cell, using low-cost metals to replace part or all of the silver paste, silver-aluminum paste, and aluminum paste has significant advantages in reducing the production cost of crystalline silicon photovoltaic cells.

However, due to the discontinuity of continuous openings on the back-side of the existing P-type solar cell technology, aluminum-metal silicide (AlSix) can only be partially formed, and a complete electrical contact path cannot be formed during the electroplating process; secondly, due to the porous structure (see attached microscopic picture) formed in the aluminum paste printing and sintering process, a large amount of electroplating solution used during the electroplating process will not only damage the wire soldering pads formed by the silver aluminum paste printing on the back-side of the double-sided P-type solar cell, but will also remain in the porous structure, which has an unpredictable negative impact on the quality and reliability of the solar cell.

### SUMMARY OF THE INVENTION

In order to overcome the above deficiencies, it is an object of the present invention to provide a manufacturing method for the back-side structure of a double-sided P-type solar cell, wherein the manufacturing method smoothly replaces expensive silver paste printing process with low-cost copper electroplating process for the double-sided P-type solar cell, thereby greatly increasing the generation efficiency and reducing the production cost of the double-sided P-type solar cell; meanwhile, by using copper electroplating instead of silver paste screen printing, the manufacturing method can increase the effective light-receiving area and increase the fill factor (FF) of the double-sided P-type solar cell to improve the overall solar cell power generation efficiency.

In order to achieve the above object, the present invention provides a method for manufacturing a back-side structure of a double-sided P-type solar cell, comprising the following steps of: step 1: forming a passivation layer on the back-side of a solar cell substrate (1), which is characterized in that the passivation layer is consisted of at least one layer of aluminum oxide (Al₂O₃) and at least one layer of silicon nitride (SiNx); step 2: using a laser to eliminate the passivation layer to form a continuous opening of exposing a silicon substrate layer (4); step 3: performing alignment printing of an aluminum paste or using a metal sputtering/evaporation method on the continuous opening of exposing the silicon substrate layer (4) to grow an aluminum metal layer; step 4: sintering the aluminum paste or the aluminum metal layer at 500-800°C to form an aluminum-metal silicide (AlSix) (5); step 5: removing the aluminum paste or the aluminum metal layer; and step 6: electroplating nickel (Ni) (6), copper (Cu) (7), and tin (Sn)/silver (Ag) (8) on the aluminum-metal silicide (AlSix) (5) sequentially.

### BRIEF DESCRIPTION OF THE DRAWINGS

Fig.1(a) illustrates a top view of a structure of step 1 of an embodiment of the present invention;
Fig.1(b) illustrates a front view of the structure of step 1;
Fig.1(c) illustrates a perspective view of the structure of step 1;
Fig.2(a) illustrates a top view of the structure of step 2 of the embodiment;
Fig.2(b) illustrates a cross-sectional view of the A-A structure of Fig2(a) in step 2;
Fig.2(c) illustrates a perspective view of the structure of step 3;
Fig.3(a) illustrates a top view of the structure of step 3 of the embodiment;
Fig.3(b) illustrates a cross-sectional view of the B-B structure of Fig.3(a) in step 3;
Fig.3(c) illustrates a perspective view of the structure of step 3;
Fig.4(a) illustrates a top view of the structure of step 4 of the embodiment;
Fig.4(b) illustrates a front view of the structure of step 4;
Fig.4(c) illustrates a perspective view of the structure of step 4;
Fig.5(a) illustrates a top view of the structure of step 5 of the embodiment;
Fig.5(b) illustrates a front view of the structure of step 5;
Fig.5(c) illustrates a perspective view of the structure of step 5;
Fig.6(a) illustrates a top view of the structure of step 6 of the embodiment;
Fig.6(b) illustrates a front view of the structure of step 6; and
Fig.6(c) illustrates a perspective view of the structure of step 6.

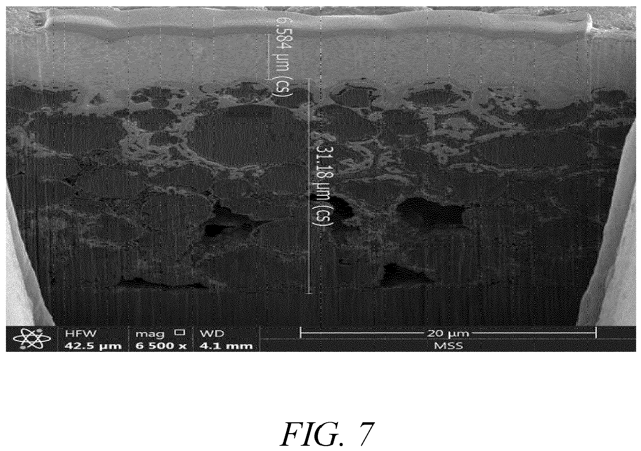

Fig.7 is a microscopic picture of the porous structure formed after aluminum paste printing and sintering.

### [Reference Numerals]

- 1: solar cell substrate
- 2: aluminum oxide (Al₂O₃)
- 3: silicon nitride (SiNx)
- 4: silicon substrate
- 5: aluminum-metal silicide (AlSix)
- 6: nickel (Ni)
- 7: copper (Cu)
- 8: tin(Sn)/silver(Ag)

### DETAILED DESCRIPTION OF THE PREFERRED EMBODIMENTS

The preferred embodiments of the present invention will be described in detail below in conjunction with the accompanying drawings, so that the advantages and features of the present invention can be more easily understood by those skilled in the art, so as to make a clearer definition of the scope of the present invention.

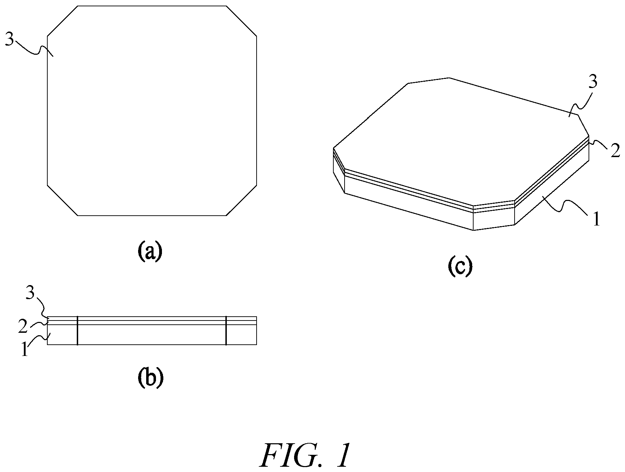

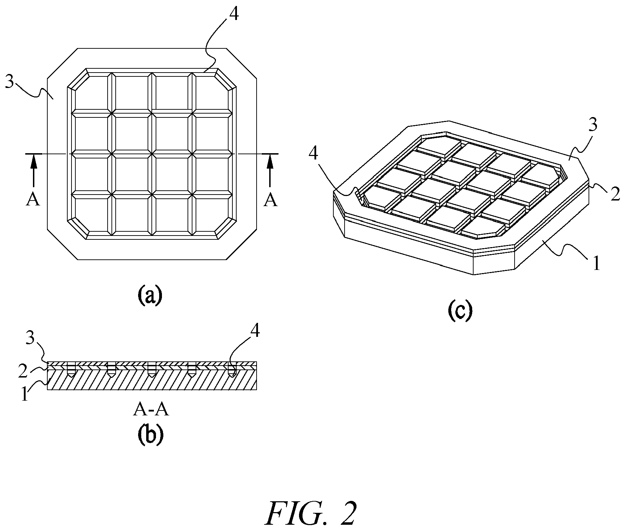

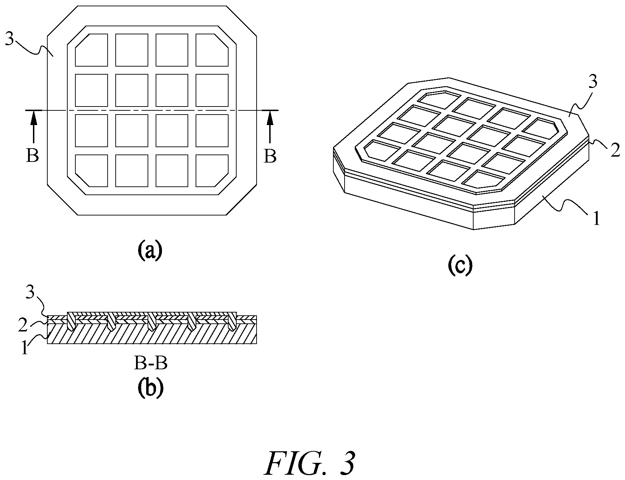

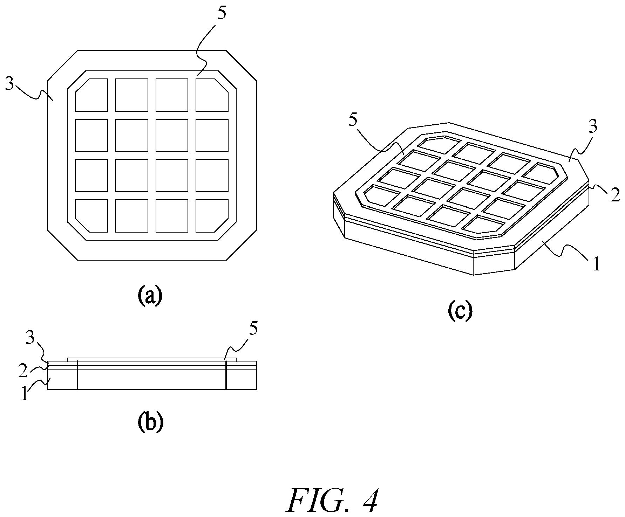

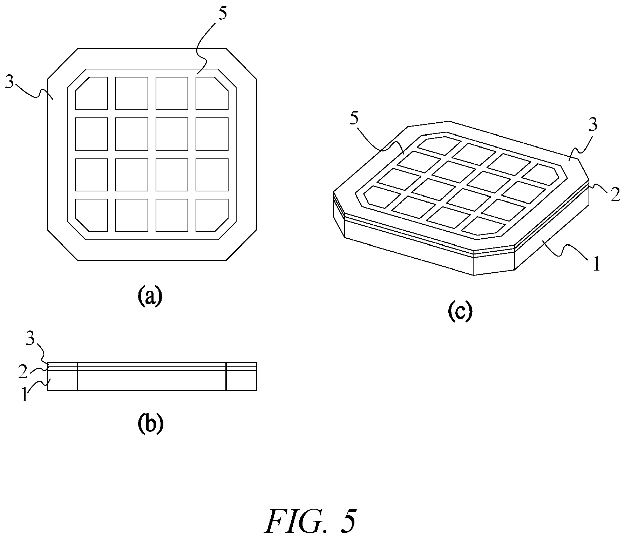

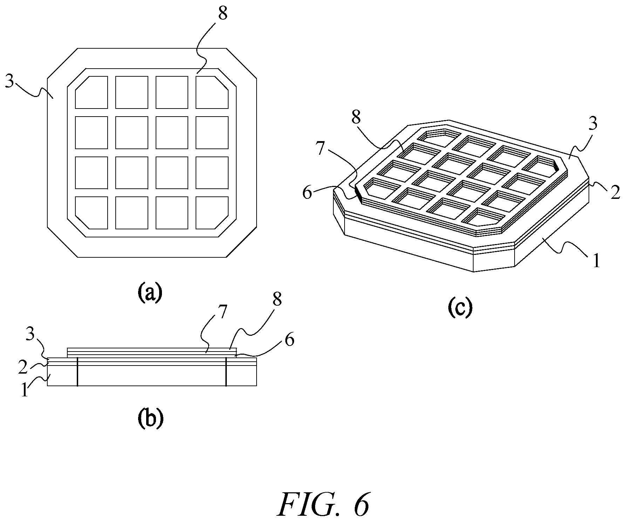

Referring to Figs 1(a) to 6(c), the manufacturing method of the back-side structure of a double-sided PERC solar cell of the embodiment includes the following steps:
Step 1 : Using CVD process to prepare a passivation layer consisted of at least one layer of aluminum oxide (Al₂O₃) 2 and at least one layer of silicon nitride (SiNx) 3 on the back-side of the solar cell substrate 1;
Step 2: Next, using nanosecond or picosecond laser to eliminate the passivation layer consisted of aluminum oxide (Al₂O₃) 2 and silicon nitride (SiNx) 3 to form a continuous opening of exposing the silicon substrate layer 4;
Step 3: Next, using alignment screen printing on the continuous of opening exposing the silicon substrate layer 4 to completely cover the aluminum paste on the continuous opening, or using metal sputtering/evaporation to grow a layer of aluminum metal layer
Step 4: Next, placing the solar cell substrate 1 in an environment of 500-800° C. to sinter the aluminum paste or the aluminum metal layer for 30-60 minutes to form critical aluminum-metal silicide (AlSix) 5;
Step 5: Removing part or all of the aluminum paste or the aluminum metal layer;
Step 6: Finally, the aluminum-metal silicide (AlSix) 5 can be sequentially electroplated with metal wires such as nickel (Ni) 6 + copper (Cu) 7 + tin (Sn)/Silver (Ag) 8.

Since critical aluminum-metal silicide (AlSix) 5 is formed on the back-side of the solar cell substrate 1, a good electrical contact path can be formed on the back-side of the solar cell substrate 1 with the cathode during the electroplating process; thus, the impedance can be significantly decreased, and a complete electroplating circuit can be formed which is beneficial to facilitate the high currents flow during electroplating; in addition, the structure of the present invention can greatly increase the effective light-receiving area of the solar cell and increase the fill factor (FF), thereby improving the overall power generation efficiency of the overall double-sided PERC solar cell.

In step 2, the continuous opening formed after using laser to eliminate the passivation layer consisted of the aluminum oxide (Al₂O₃) 2 and the silicon nitride (SiNx) 3 to expose the silicon substrate layer 4 occupies 2% to 98% of the area of the passivation layer.

In step 3, an aluminum paste is printed on the continuous opening of exposing the silicon substrate layer 4, wherein the printed line width of the aluminum paste must be able to completely cover the continuous opening formed after laser eliminate the passivation layer, and the thickness of the aluminum paste is not greater than 3 µm.

At the same time, in step 3, the metal sputtering/evaporation method is used for growing a layer of the aluminum metal layer, wherein the thickness of the aluminum metal layer is not greater than 990 nm.

Furthermore, after step 5 of removing the aluminum paste or the aluminum metal layer, the aluminum-metal silicide (AlSix) 5 can be used as the conductive seed layer for direct electroplating process in the step 6.

Besides, after step 5 of removing the aluminum paste or the aluminum metal layer, in step 6 of electroplating nickel (Ni) 6, copper (Cu) 7, and tin (Sn)/silver (Ag) 8 on the aluminum-metal silicide (AlSix) 5 sequentially, a double-sided electroplating process can be performed simultaneously to the front surface of the solar cell substrate 1.

The back-side structure of a double-sided P-type solar cell in the embodiment allows the double-sided P-type photovoltaic cell of the present invention to be subjected to a double-sided electroplating process, not only ensuring that the back-side of the cell is processed by a double-sided horizontal electroplating equipment, but also ensuring that during the electroplating process, the back-side structure will not be damaged by the electroplating solution, nor will it cause the solution to remain in the porous structure on the back-side, thereby avoiding the negative impact on the quality and reliability of the cell.

While the preferred embodiments of the invention have been set forth for the purpose of disclosure, modifications of the disclosed embodiments of the invention as well as other embodiments thereof may occur to those skilled in the art. Accordingly, the appended claims are intended to cover all embodiments which do not depart from the spirit and scope of the invention.

## Claims

1. A method for manufacturing a back-side structure of a double-sided P-type solar cell, comprising the following steps of:
step 1: forming a passivation layer on the back-side of a solar cell substrate (1);
step 2: using a laser to eliminate the passivation layer to form a continuous opening of exposing a silicon substrate layer (4);
step 3: performing alignment printing of an aluminum paste or using a metal sputtering/evaporation method on the continuous opening of exposing the silicon substrate layer (4) to grow an aluminum metal layer;
step 4: sintering the aluminum paste or the aluminum metal layer at 500-800°C to form an aluminum-metal silicide (AlSix) (5);
step 5: removing the aluminum paste or the aluminum metal layer; and
step 6: electroplating nickel (Ni) (6), copper (Cu) (7), and tin (Sn)/silver (Ag) (8) on the aluminum-metal silicide (AlSix) (5) sequentially.

2. The method for manufacturing a back-side structure of a double-sided P-type solar cell as claimed in Claim 1, wherein the passivation layer includes at least one layer of aluminum oxide (Al₂O₃) (2) and at least one layer of silicon nitride (SiNx) (3).

3. The method for manufacturing a back-side structure of a double-sided P-type solar cell as claimed in Claim 1, wherein in the step 2 of using a laser to eliminate the passivation layer consisted of (Al₂O₃) (2) and (SiNx) (3) to form a continuous opening of exposing a silicon substrate layer (4), the continuous opening occupies 2% to 98% of area of the passivation layer.

4. The method for manufacturing a back-side structure of a double-sided P-type solar cell as claimed in Claim 1, wherein in the step 3 of performing alignment screen printing of an aluminum paste on a continuous opening of exposing the silicon substrate layer (4), the printing line width of the aluminum paste is able to completely cover the continuous opening on the passivation layer after the passivation layer is eliminated, and the thickness of the aluminum paste is not greater than 3µm.

5. The method for manufacturing a back-side structure of a double-sided P-type solar cell as claimed in Claim 1, wherein in the step 3 of using a metal sputtering/evaporation method to grow an aluminum metal layer, the thickness of the aluminum metal layer is no greater than 990nm.

6. The method for manufacturing a back-side structure of a double-sided P-type solar cell as claimed in Claim 1, wherein after the step 5 of removing the aluminum paste or the aluminum metal layer, the aluminum-metal silicide (AlSix) (5) can be used as the conductive seed layer for direct electroplating process in the step 6.

7. The method for manufacturing a back-side structure of a double-sided P-type solar cell as claimed in Claim 1, wherein after the step 5 of removing the aluminum paste or the aluminum metal layer, in the step 6 of electroplating nickel (Ni) (6), copper (Cu) (7), and tin (Sn)/silver (Ag) (8) on the aluminum-metal silicide (AlSix) (5) sequentially, a double-sided electroplating process can be performed simultaneously to the front surface of the solar cell substrate (1).
